# FASCICULE DE BREVET EUROPEEN

(11) **EP 2 054 929 B1**
(45) Date de publication et mention de la délivrance du brevet: **16.03.2016**
(21) Numéro de dépôt: 07788221.5
(22) Date de dépôt: 03.08.2007
(51) Int. Cl.: H01L 21/683, H01L 21/66, H01L 21/56, H01L 25/065, H01L 21/98

(54) **PROCEDE DE FABRICATION COLLECTIVE DE MODULES ELECTRONIQUES 3D**
PROZESS ZUR KOLLEKTIVEN HERSTELLUNG VON ELEKTRONISCHEN 3D-MODULEN
PROCESS FOR THE COLLECTIVE MANUFACTURING OF ELECTRONIC 3D MODULES

(30) Priorité: 22.08.2006 FR 0607442
(43) Date de publication de la demande: 06.05.2009
(73) Titulaire: 3D Plus, 78532 Buc Cedex (FR)
(72) Inventeur: VAL, Christian, F-78470 St Remy Les Chevreuse (FR)
(74) Mandataire: Henriot, Marie-Pierre
(86) Numéro de dépôt international: PCT/EP2007/058090
(87) Numéro de publication internationale: WO 2008/022901

(56) Documents cités:
- EP-A- 1 041 620
- JP-A- 2001 210 782
- JP-A- 2001 332 685

## Description

Le domaine de l'invention est celui de la fabrication de modules électroniques 3D.

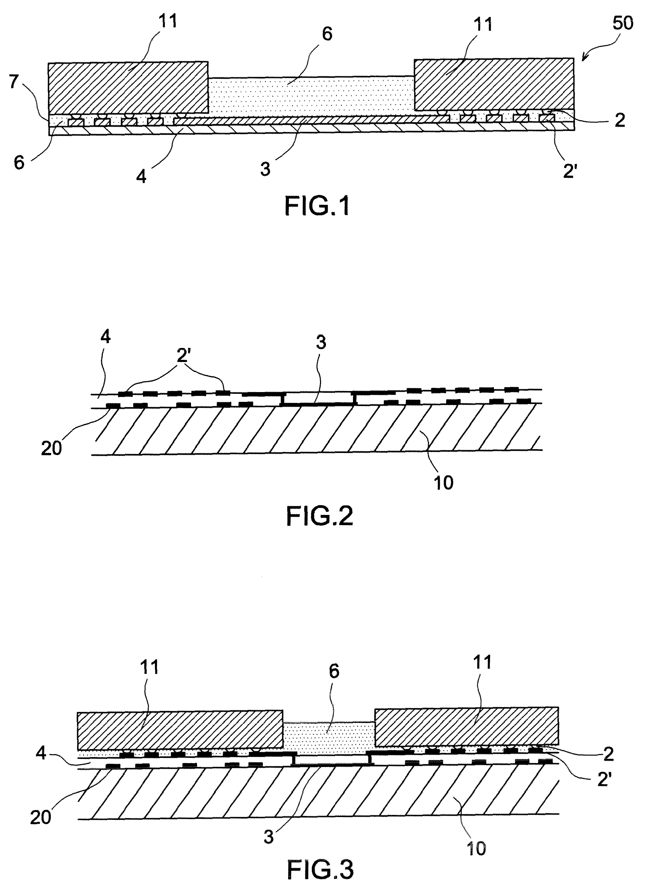

Un module électronique 3 D comprend un empilement de tranches électroniques dont l'interconnexion s'effectue en trois dimensions en utilisant les faces de l'empilement pour réaliser les connexions entre les tranches. Une tranche 50 dont un exemple est représenté figure 1, comprend généralement un ou plusieurs composants 11 actifs ou passifs qui ont des éléments de connexion électrique 2, les composants étant enrobés dans une résine 6 électriquement isolante. Les éléments de connexion 2 des composants sont reliés à des plots de connexion 2' portés par un substrat électriquement isolant 4. Une ou plusieurs pistes 3 électriquement conductrices portées par le substrat isolant 4 relient ces composants entre eux ou les relient à des éléments de connexion électrique des tranches entre elles. Les tranches sont reliées électriquement entre elles par des conducteurs situés sur les faces latérales de l'empilement, c'est-à-dire sur les bords 7 des tranches.

Un procédé de fabrication de modules électroniques 3D est décrit dans le document EP 1 041 620 A.

Il existe plusieurs méthodes pour connecter les plots 2 du composant à ceux 2' du substrat.

Une méthode consiste à connecter directement les plots du composant sur ceux du substrat isolant en envoyant des ultra-sons. L'énergie envoyée est proportionnelle au nombre de plots à connecter. Pour des composants comportant un grand nombre de plots, l'énergie nécessaire pour la connexion provoque parfois une cassure du composant. Une solution pour réduire cette énergie consiste à chauffer le substrat qui alors s'amollit et absorbe une partie de l'énergie ultrasonore envoyée ce qui rend la connexion très difficile. En outre, lors de l'enrobage des composants par polymérisation réalisée à environ 150°, le substrat tend à se courber car le coefficient de dilation des composants est différent de celui du substrat, typiquement 4 fois inférieur.

Les tranches ainsi obtenues sont testées électriquement une par une de manière à éliminer les tranches comportant un composant défectueux avant d'être empilées de manière à obtenir un module électronique 3D.

Le but de l'invention est de pallier ces inconvénients pour réaliser des modules 3D ne comportant pas de composants défectueux.

Le principe de l'invention est de conserver une bonne continuité de matériau entre le composant et le substrat pendant la fabrication pour éviter les différences de dilatation pendant l'étape de connexion et/ou de polymérisation, tout en permettant de réaliser un test électrique collectif. De cette façon l'étape d'empilement permettant de réaliser des modules électroniques 3D n'est réalisée qu'avec des tranches comportant des composants valides.

Plus précisément l'invention a pour objet un procédé de fabrication de n modules électroniques, n étant un entier supérieur à 1, un module comportant un empilement de K tranches électroniques, une tranche i, i variant de 1 à K comprenant sur un substrat isolant au moins un composant électronique, les K tranches étant reliées électriquement entre elles par des conducteurs situés sur les faces latérales de l'empilement, caractérisé en ce que la fabrication est collective et comprend :
une première étape consistant pour chaque tranche i, en :
   A1) une étape de fabrication d'un lot de n tranches i sur une même plaque mince plane d'épaisseur eₛ comprenant du silicium, recouverte sur une face de plots de connexion électrique dits plots de test puis d'une couche mince électriquement isolante d'épaisseur eᵢ, formant le substrat isolant et munie d'au moins un composant électronique en silicium comportant des plots de connexion connecté aux plots de test à travers ladite couche isolante, les composants étant enrobés d'une résine isolante d'épaisseur eᵣ, remplissant les espaces entre les composants, puis séparés les uns des autres par des premières rainures d'une largeur L1 et d'une profondeur P1 telle que eᵢ+eᵣ<P1 < eᵢ+eᵣ+eₛ, les plots de connexion des composants étant connectés à des pistes qui affleurent au niveau des rainures,
   B1) une étape de dépôt d'un support adhésif sur la face côté composants,
   C1) une étape de retrait de la plaque de silicium de manière à faire apparaître les plots de test,
   D1) une étape de test électrique des composants de la plaque par les plots de test, et de marquage des composants valides et/ou défectueux,
   E1) une étape de report sur un film adhésif des tranches valides comportant chacune un composant valide connecté à des plots de test, de la résine isolante, une couche isolante, au moins une piste, les tranches étant séparées par des deuxièmes rainures de largeur L2 au niveau desquelles affleurent les pistes de connexion des composants valides,
une deuxième étape consistant à :
   A2) empiler et assembler les K lots obtenus à l'issue de la première étape, de manière à superposer les deuxièmes rainures, sensiblement les unes sur les autres,
   B2) former des troisièmes rainures dans les empilements au niveau des deuxièmes rainures sur une largeur L3 ≥ L2,
   C2) interconnecter les tranches entres elles au niveau de la paroi desdits trous.

Ce procédé permet d'isoler les tranches afin de les tester de manière collective au niveau de la plaque, de reconstituer une autre plaque avec des composants valides et de réaliser ces troisièmes rainures suffisamment larges de façon à obtenir des sections de pistes conductrices bien nettes au niveau de ces rainures.

Il permet ainsi de réaliser de manière collective des modules 3D ne comportant pas de composants défectueux.

De préférence, il comprend préalablement à l'étape de dépôt d'un support adhésif sur la face côté composants, une étape d'amincissement de la plaque par surfaçage de la face de la plaque comportant les composants.

Avantageusement L2<L1.

Selon une caractéristique de l'invention l'empilement de l'étape A2 est réalisé sur un support et il comprend après l'étape C2 de métallisation, une étape de découpe de ce support au niveau des troisièmes rainures en vue d'obtenir les n modules électroniques 3D.

Le composant électronique peut être un composant actif ou un composant passif ou un MEMS (acronyme de l'expression anglo-saxonne Micro Electro Mechanical System).

D'autres caractéristiques et avantages de l'invention apparaîtront à la lecture de la description détaillée qui suit, faite à titre d'exemple non limitatif et en référence aux dessins annexés dans lesquels :
la figure 1 déjà décrite représente schématiquement une vue en coupe d'une tranche électronique d'un module 3D, selon l'état de la technique,
la figure 2 représente schématiquement une vue en coupe de la première étape du procédé de fabrication collective de modules 3D selon l'invention,
la figure 3 représente schématiquement une vue en coupe de la deuxième étape de montage des composants du procédé selon l'invention,
la figure 4 représente schématiquement une vue en coupe de la troisième étape de découpe de premières rainures du procédé selon l'invention,
la figure 5 représente schématiquement une vue en coupe de la quatrième étape de surfaçage du procédé selon l'invention,
la figure 6 représente schématiquement une vue en coupe de la cinquième étape d'attaque chimique de la plaque de silicium du procédé selon l'invention,
la figure 7 représente schématiquement une vue en coupe de la sixième étape de test électrique des composants du procédé selon l'invention,
la figure 8 représente schématiquement une vue en coupe de la septième étape de reconstitution d'une nouvelle plaque ne comportant que des composants valides du procédé selon l'invention,
la figure 9 représente schématiquement une vue en coupe de la huitième étape d'empilement des plaques reconstituées du procédé selon l'invention,
la figure 10 représente schématiquement une vue en coupe de la neuvième étape de découpe de secondes rainures du procédé selon l'invention,
la figure 11 représente schématiquement une vue en coupe de la dixième étape de métallisation des secondes rainures du procédé selon l'invention,
la figure 12 représente schématiquement une vue en coupe de la onzième étape de gravure des faces latérales des n modules du procédé selon l'invention.

D'une figure à l'autre, les mêmes éléments sont repérés par les mêmes références.

Un module électronique 3D comporte un empilement de K tranches électroniques 50 ; une tranche i, i variant de 1 à K comprend sur un substrat isolant 4 au moins un composant électronique 11. Un composant a typiquement une épaisseur comprise entre 50 µm et 500 µm. Le composant peut être un composant actif tel qu'une puce (diode, transistor, circuit intégré, ...) ou un composant passif classique tel qu'un condensateur. Ce peut être également un composant passif gravé dans le silicium, connu sous le terme MEMS acronyme de l'expression anglo-saxonne Micro ElectroMechanical System assurant des fonctions de type capteur, actuateur, commutateur, etc : un MEMS est agencé dans une cavité protégée par un capot.

Les K tranches sont reliées électriquement entre elles par des conducteurs situés sur les faces latérales de l'empilement. K est par exemple égal à 4 mais varie typiquement entre 2 et 100.

L'invention concerne la fabrication de n modules ne comportant que des composants valides (n compris entre 2 et 100 selon la dimension de ceux-ci), cette fabrication étant collective.

Elle comprend une étape de fabrication d'un lot de n tranches i sur une même plaque, cette étape étant répétée K fois, puis une étape d'empilement des K plaques, de formation de rainures dans l'épaisseur de l'empilement destinés à la connexion des tranches entre elles, pour obtenir les n modules 3D.

Un lot de n tranches i est obtenu à l'issue de plusieurs sous-étapes décrites en relation avec les figures 2 à 8.

Une même plaque 10 mince plane d'épaisseur eₛ comprenant du silicium est recouverte sur une face de plots 20 de connexion électrique dits plots de test puis d'une couche mince électriquement isolante d'épaisseur eᵢ de quelques µm, formant le substrat isolant 4 et munie d'au moins n composants électroniques 11 en silicium dont les plots de connexion 2 ou bossages connectés à des plots de connexion 2' sont connectés aux plots de test à travers ladite couche isolante (figures 2 et 3). La couche mince isolante 4 est par exemple en résine isolante photogravable. Les composants 11 sont reportés sur le substrat isolant, face active vers le substrat selon une méthode dite « Flip Chip » par fusion de leurs bossages ou par « Stud Bumping » ; ce procédé de Stud Bumping consiste à souder des boules en or grâce à un procédé thermosonique bien connu pour le collage des fils en or.

Les composants 11 sont enrobés d'une résine isolante 6 d'épaisseur eᵣ, remplissant les espaces entre les composants 11 et entre les composants 11 et la couche isolante 4 (figure 3).

L'épaisseur eᵢ est typiquement comprise entre 5 et 20 µm et eᵣ entre 50 et 500 µm.

L'épaisseur de la plaque 10 est de l'ordre de quelques centaines de µm. Des composants passifs sont éventuellement déjà dans la plaque dans la partie supérieure de celle-ci à environ 10-20 µm de profondeur. Cette plaque 10 assure un support continu de fabrication du lot de n tranches i. Il s'agit par exemple d'une plaque circulaire d'un diamètre d'environ 25 cm.

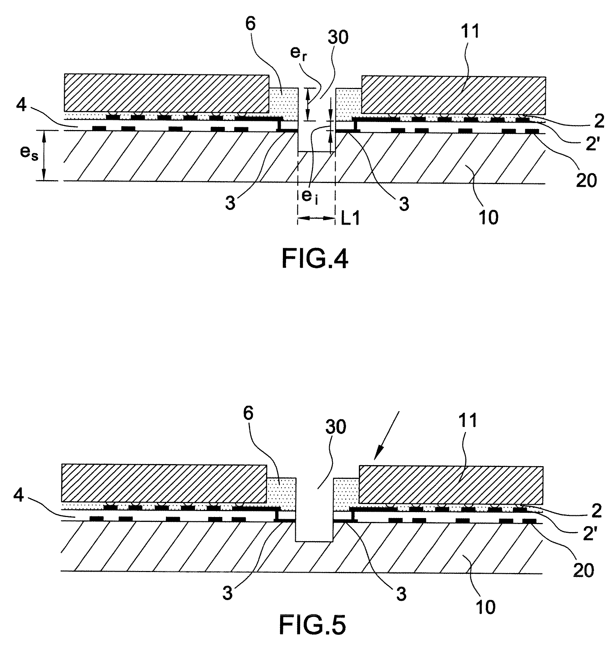

En vue du test électrique de chaque composant, les composants sont alors séparés les uns des autres par des premières rainures 30 d'une largeur L1 et d'une profondeur P1 telle que eᵢ+eᵣ<P1<eᵢ+eᵣ+eₛ ; ces rainures découpées dans la résine isolante 6 sont par exemple obtenues par sciage (figure 4). On a typiquement L1 compris entre 25 et 75 µm. Les plots 2 de connexion des composants sont reliés à des éléments d'interconnexion électrique du composant tels que des pistes 3 qui affleurent au niveau de ces rainures 30. Sur les figures les pistes sont au niveau des plots de test 20 ; elles peuvent être également au niveau des plots de connexion 2'.

De préférence, le procédé comprend en outre une étape consistant à amincir la plaque munie de ses composants par un surfaçage hétérogène de la plaque côté composants, c'est-à-dire par un surfaçage appliqué de façon non sélective à la fois aux composants 11 et éventuellement à la résine 6 les enrobant ; ce surfaçage obtenu par exemple par polissage est indiqué par une flèche sur la figure 5. De manière générale on désigne par plaque ou « wafer » en anglais, l'ensemble de la structure obtenue au fur et à mesure du procédé de fabrication. Ce surfaçage collectif peut être réalisé avant la réalisation des premières rainures. Le surfaçage est réalisé par abrasion mécanique ou chimique. L'épaisseur de la plaque avec ses composants est alors diminuée.

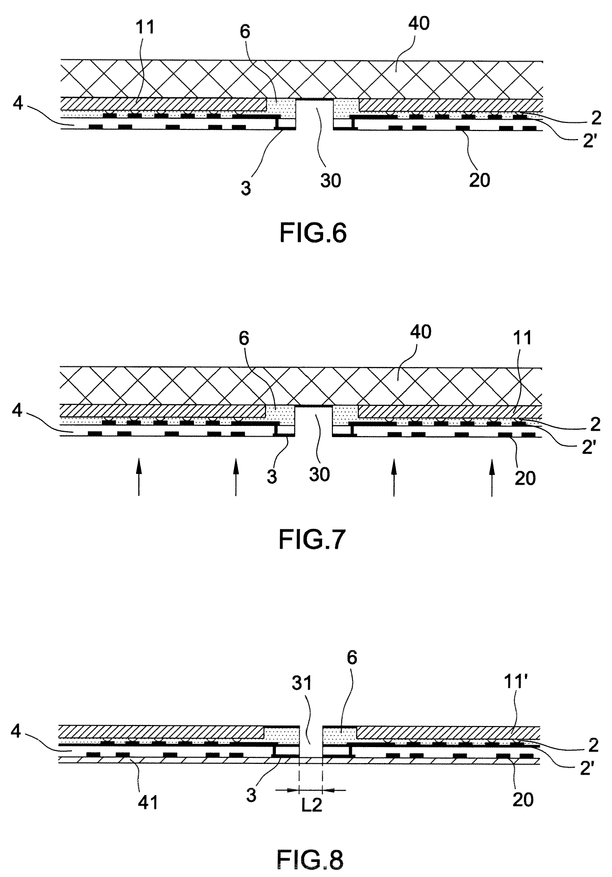

Un support adhésif 40 est déposé côté composants 11, sur la face éventuellement surfaçée et la plaque de silicium 10 d'origine est supprimée par attaque chimique par exemple, de manière à faire apparaître les plots de test 20 (figure 6). Ce support adhésif peut être une feuille adhésive comme par exemple une feuille en chlorure de polyvinyle, couramment appelée peau de tambour qui peut être décollée sans traitement particulier par pelage par exemple : elle permet d'éviter le collage par colle des composants qui nécessite un traitement thermique pour polymériser la colle et un traitement chimique par acide pour le retirer. A l'issue de cette étape la plaque a une épaisseur d'environ 100 µm, plus généralement comprise entre 50 µm et 200 µm.

Les composants sont alors électriquement testés au moyen des plots de test 20, et marqués selon qu'ils sont valides ou défectueux ; le test est indiqué par des flèches sur la figure 7. Ce marquage peut simplement consister à mettre de côté les tranches défectueuses. On désigne par tranche valide l'élément comportant un composant valide 11' connecté à des plots de test 20 et à au moins une piste conductrice 3, la résine 6, la couche isolante 4. De cette façon, le test est réalisé de manière collective plutôt qu'individuellement sur chaque module obtenu.

Les tranches testées et valides sont détachées du support adhésif 40 de la plaque et reportées sur un autre substrat 41 tel qu'un autre film adhésif du type de celui décrit précédemment, de manière à reconstituer une deuxième plaque dite « Known Good Wafer », ne comportant que des composants valides 11' (figure 8). Les tranches sont reportées sur le substrat 41 de manière à ménager un espace inter-tranches minimal pour placer le maximum de tranches par unité de surface : ces espaces de séparation forment des rainures 31 de largeur L2 avec de préférence L2<L1 au niveau desquelles affleurent les pistes 3 reliées aux plots de connexion des composants 2. Il n'y a pas de dépôt de résine dans ces rainures 31.

La fabrication collective de ce lot de n tranches 50 est répétée K fois en vue d'obtenir les K plaques de « Known Good Wafer ».

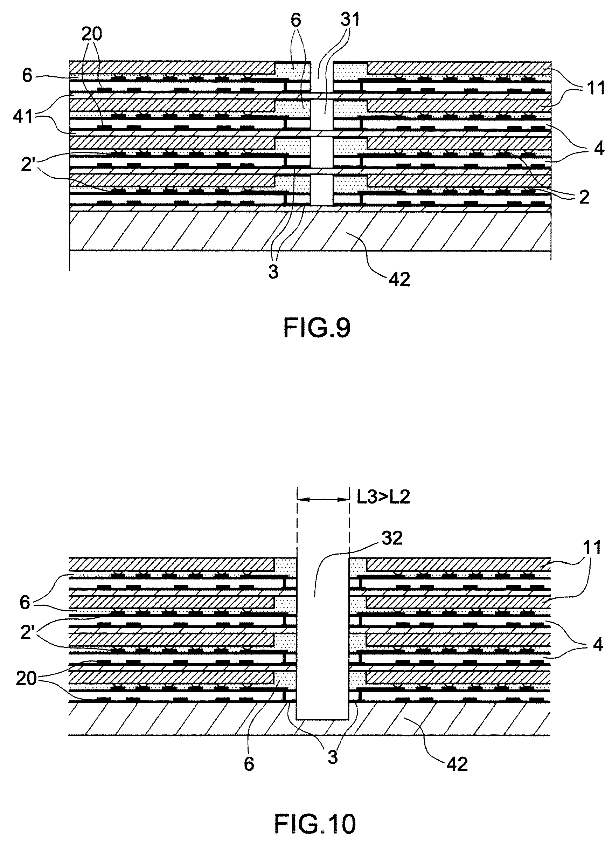

Une deuxième étape comportant des sous-étapes décrites en relation avec les figures 9 à 12 consiste à empiler les K lots de « Known Good Wafer » obtenus à l'issue de la première étape, comme illustré figure 9 avec K = 4, de manière à superposer les deuxièmes rainures 31 de chaque lot, sensiblement les unes sur les autres. Les plaques sont empilées les unes sur les autres par exemple au moyen d'adhésifs. De préférence l'empilement est réalisé sur un support adhésif 42 ou peau de tambour, d'une épaisseur d'environ 25 µm. Ces deuxièmes rainures sont de préférence de mêmes dimensions, mais pas nécessairement. Des troisièmes rainures 32 sont alors formées sur toute l'épaisseur de l'empilement à l'aplomb des rainures 31 sur une largeur L3 (figure 10) supérieure à L2, inférieure à L1 de manière à ce que les pistes 3 affleurent sur la paroi de ces troisièmes rainures. Ces rainures sont par exemple obtenues par sciage.

La dimension transverse L3 des rainures 32 est supérieure à L2 et de préférence supérieure à L1, d'une part pour compenser les éventuels décalages lors de l'empilement des K « Known Good Wafer » et d'autre part pour que les pistes 3 reliées aux plots de connexion des composants affleurent au niveau de ces rainures. On a L3 compris entre par exemple de 50 µm à 100 µm.

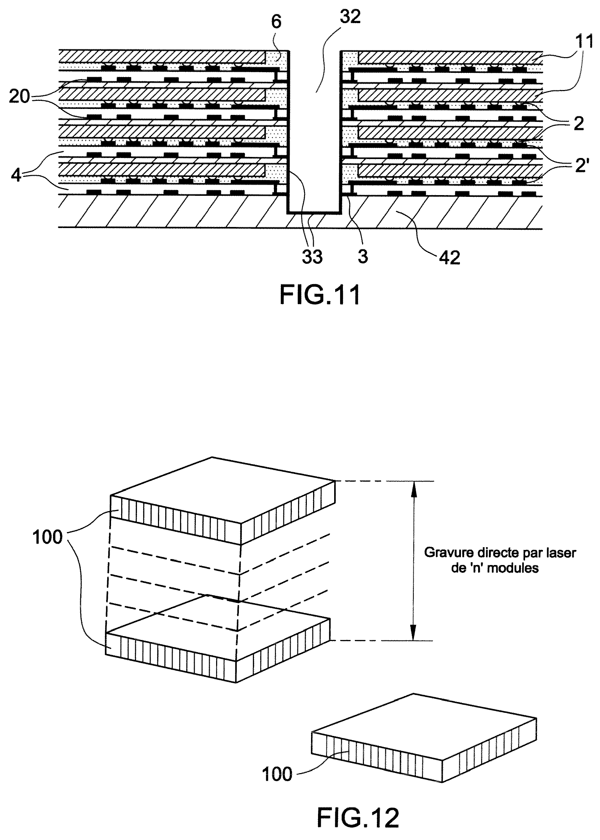

La paroi des rainures 32 est alors métallisée avec une couche métallique 33 (figure 11) par dépôt chimique et/ou électrochimique ou par pulvérisation cathodique sous vide, mettant en court-circuit l'ensemble des pistes aboutissant sur la paroi des trous. L'éventuel support adhésif 42 est découpé dans le prolongement des trous 32 en vue d'obtenir les n modules électroniques. Cette découpe est par exemple effectuée par sciage.

Une étape de gravure des n modules par exemple par laser permet d'isoler des groupes de pistes pour former le schéma d'interconnexion des tranches entre elles (figure 12). A l'issue de cette étape, on obtient les n modules 3D 100 dont un exemple est représenté figure 12. Cette gravure est avantageusement effectuée collectivement : à cet effet des modules sont empilés (par exemple une centaine) contre 2 bords de référence formés par une équerre, préalablement à cette gravure.

## Revendications

1. Procédé de fabrication de n modules électroniques (100), n étant un entier supérieur à 1, un module comportant un empilement de K tranches électroniques (50), une tranche i, i variant de 1 à K comprenant sur un substrat isolant (4) au moins un composant électronique (11), les K tranches étant reliées électriquement entre elles par des conducteurs situés sur les faces latérales de l'empilement, **caractérisé en ce que** la fabrication est collective et comprend :
une première étape consistant pour chaque tranche i, en :
A1) une étape de fabrication d'un lot de n tranches i sur une même plaque mince (10) plane d'épaisseur eₛ comprenant du silicium, recouverte sur une face de plots de connexion électrique (20) dits plots de test puis d'une couche mince électriquement isolante (4) d'épaisseur eᵢ, formant le substrat isolant et munie d'au moins un composant électronique (11) en silicium comportant des plots de connexion (2) connecté aux plots de test (20) à travers ladite couche isolante, les composants étant enrobés d'une résine isolante (6) d'épaisseur eᵣ, remplissant les espaces entre les composants, puis séparés les uns des autres par des premières rainures (30) d'une largeur L1 et d'une profondeur P1 telle que eᵢ+eᵣ<P1 < eᵢ+eᵣ+eₛ, les plots de connexion des composants (2) étant connectés à des pistes (3) qui affleurent au niveau des rainures (30),
B1) une étape de dépôt d'un support adhésif (40) sur la face côté composants,
C1) une étape de retrait de la plaque de silicium (10) de manière à faire apparaître les plots de test (20),
D1) une étape de test électrique des composants par les plots de test (20), et de marquage des composants valides (11') et/ou défectueux,
E1) une étape de report sur un film adhésif (41) des tranches (50) comportant chacune un composant valide (11') connecté à des plots de test (20) et à au moins une piste (3), de la résine isolante (6), une couche isolante (4), les tranches étant séparées par des deuxièmes rainures (31) de largeur L2 au niveau desquelles affleurent les pistes de connexion (3) des composants valides (11'),
une deuxième étape consistant à :
A2) empiler et assembler les K lots de tranches obtenus à l'issue de la première étape, de manière à superposer les deuxièmes rainures (31), sensiblement les unes sur les autres,
B2) former des troisièmes rainures (32) dans les empilements au niveau des deuxièmes rainures sur une largeur L3 ≥ L2,
C2) interconnecter les tranches entre elles au niveau de la paroi des troisièmes rainures (32).

2. Procédé selon la revendication précédente, **caractérisé en ce que** L2<L1.

3. Procédé selon l'une quelconque des revendications précédentes, **caractérisé en ce qu'**il comprend préalablement à l'étape de dépôt d'un support adhésif sur la face côté composants, une étape d'amincissement par surfaçage de la face de la plaque comportant les composants.

4. Procédé selon l'une quelconque des revendications précédentes, **caractérisé en ce que** l'étape C2 comprend les étapes consistant à :
- métalliser la paroi des troisièmes rainures au moyen d'une couche métallique (33)
- former dans ladite couche métallique un schéma d'interconnexion des tranches entre elles.

5. Procédé selon l'une quelconque des revendications précédentes, **caractérisé en ce que** l'empilement de l'étape A2 est réalisé sur un support (42).

6. Procédé selon l'une quelconque des revendications précédentes, **caractérisé en ce que** le composant électronique (11) est un composant actif ou passif ou un MEMS.

7. Procédé selon la revendication précédente, **caractérisé en ce que** le composant actif est une puce.

8. Procédé selon l'une quelconque des revendications précédentes, **caractérisé en ce qu'**au moins un composant passif est situé dans la plaque (10) ou sur la plaque.

## Patentansprüche

1. Verfahren zur Herstellung von n elektronischen Modulen (100), wobei n eine ganze Zahl größer als 1 ist, wobei ein Modul einen Stapel von K elektronischen Wafern (50) umfasst, wobei ein Wafer i, wobei i von 1 bis K variiert, wenigstens eine elektronische Komponente (11) auf einem isolierenden Substrat (4) umfasst, wobei die K Wafer elektrisch durch Leiter miteinander verbunden sind, die sich an den Seitenflächen des Stapels befinden, **dadurch gekennzeichnet, dass** die Herstellung kollektiv ist und Folgendes beinhaltet:
einen ersten Schritt, der für jeden Wafer i Folgendes beinhaltet:
A1) einen Schritt des Herstellens eines Loses von n Wafern i auf derselben dünnen flachen Platte (10) mit einer Dicke es, umfassend Silicium, auf einer Fläche bedeckt mit elektrischen Verbindungspads (20), Prüfpads genannt, dann mit einer elektrisch isolierenden dünnen Schicht (4) mit einer Dicke eᵢ, die das isolierende Substrat bildet und mit wenigstens einer elektronischen Komponente (11) aus Silicium versehen ist, die Verbindungspads (2) umfasst, die mit den Prüfpads (20) durch die isolierende Schicht verbunden sind, wobei die Komponenten mit einem isolierenden Harz (6) mit einer Dicke eᵣ beschichtet werden, das die Lücken zwischen den Komponenten ausfüllt, die dann durch erste Nuten (30) mit einer Breite L1 und einer Tiefe P1 voneinander getrennt werden, so dass eⱼ+eᵣ<P1 < eᵢ+eᵣ+eₛ ist, wobei die Verbindungspads der Komponenten (2) mit Bahnen (3) verbunden sind, die mit der Ebene der Nuten (30) fluchten;
B1) einen Schritt des Absetzens einer Klebeauflage (40) auf die Fläche auf der Komponentenseite;
C1) einen Schritt des Entfernens der Siliciumplatte (10), um die Prüfpads (20) zu exponieren;
D1) einen Schritt des elektrischen Prüfens von Komponenten mit Prüfpads (20) und des Markierens von gültigen (11') und/oder defekten Komponenten;
E1) einen Schritt des Übertragens, auf einen Klebstofffilm (41), von Wafern (50), die jeweils eine gültige Komponente (11'), die mit Prüfpads (20) und mit wenigstens einer Bahn (3) verbunden ist, einen isolierenden Harz (6) und eine isolierende Schicht (4) beinhalten, wobei die Wafer durch zweite Nuten (31) mit einer Breite L2 getrennt sind, an denen die Verbindungsbahnen (3) der gültigen Komponenten (11') fluchten;
einen zweiten Schritt, der Folgendes beinhaltet:
A2) Stapeln und Aneinanderfügen der K Lose von Wafern, erhalten nach Abschluss des ersten Schrittes, um die zweiten Nuten (31) im Wesentlichen übereinander zu stapeln;
B2) Bilden von dritten Nuten (32) in den Stapeln an den zweiten Nuten auf einer Breite L3 ≥ L2;
C2) Verbinden der Wafer miteinander an der Wand der dritten Nuten (32).

2. Verfahren nach dem vorherigen Anspruch, **dadurch gekennzeichnet, dass** L2<L1 ist.

3. Verfahren nach einem der vorherigen Ansprüche, **dadurch gekennzeichnet, dass** es vor dem Schritt des Absetzens einer Klebeauflage auf der Fläche auf der Komponentenseite einen Schritt des Verdünnens durch Plandrehen der Fläche der Platte beinhaltet, die die Komponenten umfasst.

4. Verfahren nach einem der vorherigen Ansprüche, **dadurch gekennzeichnet, dass** Schritt C2 Schritte beinhaltet, die Folgendes beinhalten:
- Metallisieren der Wand der dritten Nuten mittels einer metallischen Schicht (33);
- Ausbilden eines Musters in der metallischen Schicht zum Verbinden der Wafer miteinander.

5. Verfahren nach einem der vorherigen Ansprüche, **dadurch gekennzeichnet, dass** der Stapel von Schritt A2 auf einer Auflage (42) erzeugt wird.

6. Verfahren nach einem der vorherigen Ansprüche, **dadurch gekennzeichnet, dass** die elektronische Komponente (11) eine aktive oder passive Komponente oder ein MEMS ist.

7. Verfahren nach dem vorherigen Anspruch, **dadurch gekennzeichnet, dass** die aktive Komponente ein Chip ist.

8. Verfahren nach einem der vorherigen Ansprüche, **dadurch gekennzeichnet, dass** sich wenigstens eine passive Komponente in der Platte (10) oder auf der Platte befindet.

## Claims

1. A method for manufacturing n electronic modules (100), with n being an integer greater than 1, a module comprising a stack of K electronic wafers (50), a wafer i, with i varying from 1 to K, comprising at least one electronic component (11) on an isolating substrate (4), said K wafers being electrically connected to each other by conductors located on the lateral faces of said stack, **characterised in that** manufacturing is collective and comprises:
a first step that for each wafer i comprises:
A1) a step of manufacturing a batch of n wafers i on the same thin flat plate (10) of thickness eₛ, comprising silicon, covered on one face with electrical connection pads (20), called test pads, then with an electrically isolating thin layer (4) of thickness eᵢ, which forms the isolating substrate and is provided with at least one electronic component (11) made of silicon, which comprises connection pads (2) connected to said test pads (20) through said isolating layer, said components being coated with an isolating resin (6) of thickness eᵣ, which fills the gaps between said components, then separated from each other by first grooves (30) having a width L1 and a depth PI, such that eᵢ+eᵣ<P1 < eᵢ+eᵣ+eₛ, said connection pads of said components (2) being connected to tracks (3) that are flush with the level of said grooves (30);
B1) a step of depositing an adhesive support (40) on the face on the component side;
C1) a step of removing said silicon plate (10) so as to expose said test pads (20);
D1) a step of electrically testing components using test pads (20) and of marking valid (11') and/or defective components;
E1) a step of transferring, on an adhesive film (41) of said wafers (50), with each wafer comprising a valid component (11') connected to said test pads (20) and to at least one track (3), an isolating resin (6) and an isolating layer (4), said wafers being separated by second grooves (31) of width L2, with said connection tracks (3) of said valid components (11') being flush at the level of said second grooves (31);
a second step comprising:
A2) stacking and assembling the K batches of wafers obtained on completion of said first step so as to superpose said second grooves (31) substantially on top of each other;
B2) forming third grooves (32) in said stacks at said second grooves on a width L3 ≥ L2;
C2) interconnecting said wafers with each other at the level of the wall of said third grooves (32).

2. The method according to the preceding claim, **characterised in that** L2<L1.

3. The method according to any one of the preceding claims, **characterised in that** it comprises, prior to said step of depositing an adhesive support on the face on the component side, a step of thinning by dressing the face of the plate comprising said components.

4. The method according to any one of the preceding claims, **characterised in that** said step C2 comprises steps comprising:
- metallising the wall of said third grooves by means of a metallic layer (33);
- forming a scheme in said metallic layer for interconnecting said wafers to each other.

5. The method according to any one of the preceding claims, **characterised in that** the stack of step A2 is produced on a support (42).

6. The method according to any one of the preceding claims, **characterised in that** said electronic component (11) is an active or passive component or an MEMS.

7. The method according to the preceding claim, **characterised in that** said active component is a chip.

8. The method according to any one of the preceding claims, **characterised in that** at least one passive component is located in the plate (10) or on the plate.
